(19) Europäisches Patentamt
European Patent Office
Office européen des brevets

(11) **EP 1 551 103 A1**

(12) **EUROPEAN PATENT APPLICATION**
published in accordance with Art. 158(3) EPC

(43) Date of publication:
06.07.2005 Bulletin 2005/27

(51) Int Cl.⁷: **H03M 13/25, H04L 27/18**

(21) Application number: 03748684.2

(86) International application number:
**PCT/JP2003/012675**

(22) Date of filing: 02.10.2003

(87) International publication number:
**WO 2004/032335 (15.04.2004 Gazette 2004/16)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: 07.10.2002 JP 2002294121

(71) Applicants:
• **Yokohama TLO Company, Ltd.**
  **Yokohama-shi, Kanagawa 240-8501 (JP)**

• **Nakamura, Makoto**
  **Machida-shi, Tokyo 194-0042 (JP)**

(72) Inventor: **NAKAMURA, Makoto**
  **Machida-shi, Tokyo 194-0042 (JP)**

(74) Representative: **Strehl Schübel-Hopf & Partner**
  **Maximilianstrasse 54**
  **80538 München (DE)**

(54) **DIGITAL COMMUNICATION METHOD AND DIGITAL COMMUNICATION DEVICE**

(57) A digital communication device includes: a modulator having encoding means for converting two-dimensional digital information signal into a three-dimensional signal and phase modulation means for modifying the carrier phase in according to the three-dimensional signal; and a demodulator having phase demodulation means for detecting information on the three-dimensional signal from the received phase-modulated wave and demodulation means for deciding the two-dimensional digital information from the information on the three-dimensional signal. The digital communication device has a bit error ratio and an occupied radio band width equivalent to a digital communication device using the conventional QPSK or π/4 shift QPSK and the error correction method and greatly improves the amplitude fluctuation. Moreover, the digital communication device can transmit a signal with a narrower occupied frequency band width while maintaining the same constant envelope characteristic as the GMSK using the conventional error correction code.

Fig. 1

**Description**

TECHNICAL FIELD

The present invention relates to a digital communication method and device utilized in digital wireless systems and so forth.

BACKGROUND ART

A digital modulation system is one that converts baseband digitalized information signals to the high frequency signals, making it an indispensable technology for a digital wireless system. Examples of digital modulation systems used in mobile communications are the PSK (Phase Shift Keying) system for making digital information correspond to the phase of a carrier wave, the FSK (Frequency Shift Keying) system for making digital information correspond to a frequency, and GMSK (Gaussian Minimum Shift Keying), which is a kind of FSK system that does not have carrier wave amplitude variations.

The performance desired in a digital modulation system comprises three elements: outstanding bit error rate characteristics versus Eb/No; a narrow radio frequency occupied bandwidth; and small amplitude variations in a modulated wave.

Here, Eb stands for the signal power per one bit of information, and No refers to the single sided noise power density of a communication channel. Firstly, with regard to the first element, an outstanding bit error rate versus Eb/No can enable highly reliable communications to be carried out at the same transmission power. Next, as for the second element, a narrow occupied bandwidth for a radio frequency makes it possible for a plurality of subscribers to be accommodated on the same frequency bandwidth. The above two elements can generally be applied to all wireless communication systems.

In addition, the third element, small amplitude variation of a modulated wave is especially important in a mobile communication system. The input/output characteristics of a power amplifier utilized in digital mobile communications, especially in a mobile terminal, possesses nonlinear characteristics. When there are amplitude variations in digital modulated radio waves, the output signal of a power amplifier with nonlinear characteristics is distorted and a frequency spectrum occurs even outside the frequency bandwidth possessed by the input signal. That is, spurious characteristics degenerate greatly. To ensure system-required spurious characteristics, channel spacing must be increased, causing a drop in subscriber capacity. Further, since the output waveform is distorted when the input-output characteristics of a power amplifier are nonlinear, inter-symbol interference occurs at the receiver, degrading the error rate. Conversely, when only the portions of the power amplifier input-output characteristics that are linear are used, the problem is that the power consumed by the power amplifier increases significantly, and the time that a mobile terminal can be used on a single charge, for example, continuous standby time, is greatly reduced.

Accordingly, FSK or GMSK, in which digital modulated radio waves constitute a constant envelope, are primarily used in mobile communications systems to avoid the effects of the nonlinear characteristics of the power amplifier. However, the problem was that the FSK and GMSK bit error rate characteristics versus Eb/No were worse than for BPSK or QPSK, and, in addition, because the occupied radio frequency bandwidth was wide, frequency utilization efficiency was poor. Accordingly, the use of BPSK and QPSK has come under review, but the problem of large radio wave amplitude variations remains as before.

Further, the problem with multivalued PSK other than QPSK is that bit error rate characteristics rapidly degenerate in line with increases in the number of phases to be utilized, and another problem is that when the number of phases to be utilized is not treated as the power of 2, signal power utilization efficiency becomes increasingly lower due to the waste generated when binary digital information is mapped to a modulated phase. Thus, most multivalued PSK other than QPSK are not being put to practical use.

Therefore, the use of error correction codes has become essential in recent wireless communications systems. For example, a convolutional code is used in digital cellular telephone systems in the United States and Japan. A convolutional code achieves an outstanding error correction effect by carrying out Viterbi decoding. A convolutional code and the Viterbi decoding algorithm are described, for example, in Literature 1 "Error Control and Coding" (S. Lin et al, McGrow Hill) and Literature 2 "Coding Theory" (Hideki Imai et al, Institute of Electronics, Information and Communications Engineers, Corona Publishing Co.).

With a convolutional code, generally speaking, changing the coding rate and constraint length will cause the error correction capability to change. A coding rate of 1/2 code is most often used. When the information to be sent is n kbits, and a coding is performed using a rate-1/2 convolutional code, the code word becomes 2n kbits. The lower the coding rate, the broader the radio frequency bandwidth needed to send the same information. Conversely, the longer the constraint length of the convolutional code, the more improved the error correction capability. However, the size of the circuitry of a Viterbi decoder increases exponentially together with the increase in the constraint length. In other words, each time the constraint length increases by 1, the size of the circuit doubles. Accordingly, cellular telephone systems use a code of constraint length 7 out of consideration for a realistic circuit size.

Thus, because the use of an error correction system is essential in a modern communication system, it is practical to evaluate the error rate versus the required bandwidth and Eb/No of a modem system that combines a digital modulation system and an error correction system. Since the error rate characteristics of an error correction system can be improved by allowing the size of the decoding circuit to increase, the modem system must be evaluated using a decoding circuit of the same size.

However, the element of the convolutional code widely used in mobile communications is generally 2, in other words, it is a binary signal. This is because digital information is generally binary, that is, it is either a 0 or a 1. However, the element of a convolutional code is not particularly limited to 2, and as long as it is a value capable of defining an operation that satisfies a field condition, it is fine. A convolutional code comprising a binary signal signifies that the code is constituted over a modulo 2 Galois field, and is described as code over GF (2). Similarly, a convolutional code comprising a p-ary signal is described as code over GF (p). However, the elements of an input signal and output signal of a convolutional encoder generally coincide, and a convolutional code in which the input and output fields differ has not been studied much at all to date. In recent years, a magnetic recording system, which uses a convolutional code that has a binary signal as its input and a ternary signal as its output has been proposed as a specific convolutional code (For example, refer to Literature 3. Japanese Patent Laid-open No. 8-180607, and Literature 4. Japanese Patent Laid-open No. 8-79320)

This was invented for adding error correction capacity without sacrificing recording density, and is characterized in that a ternary [signal] outputted from the convolutional encoder is recorded by making it correspond to a ternary magnetization state. If the saturation magnetization level is the same when recording in this state, then the output SN degenerates 6dB compared to recording using a binary magnetization state. The problem, therefore, is that this offsets the effect of the coding gain of the convolutional code achieved by a practical decoding circuit size. Thus, even the use of an optimum code configuration not disclosed in the above-mentioned Literature 3 can only achieve poor performance by which the error rate characteristics relative to Eb/No is 4dB or greater despite that fact that the required bandwidth is the same as that of conventional methods that make use of ordinary convolutional code and QPSK. Thus, hardly any application fields that can give full play to the special features of a convolutional code with a binary input and a ternary output have been found to date.

Furthermore, with a convolutional code, the error correction capacity will differ greatly in accordance with the way it is connected even when the memory length is the same. In the above-mentioned literature, the only thing that is disclosed is that the constitution is such that the error rate becomes minimal, and a concrete connection method is not described.

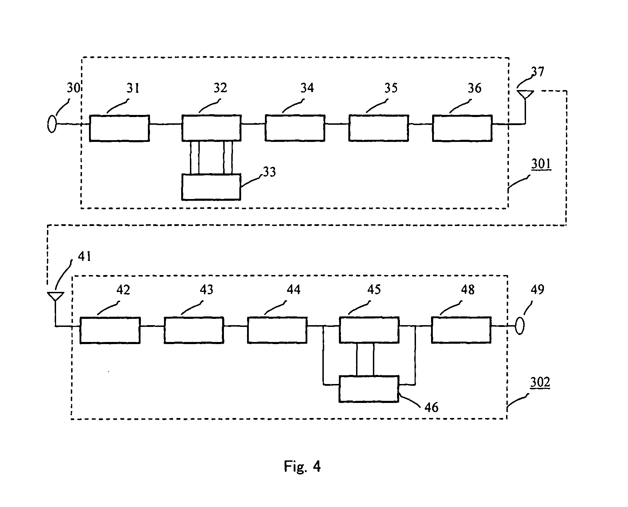

Fig. 4 is a simplified block diagram showing one example of a digital communication device that utilizes a conventional convolutional code, having a code rate of 1/2 and a constraint length of 7, and QPSK.

In a transmitter 301, digital information comprising "0", "1" is inputted to a terminal 30 at an information transmission rate of, for example, 100 bits per second (b/s). This signal is guided to a convolutional encoder 31, which outputs to a QPSK modulator 32 two bits of information for every one bit of digital information that is inputted. Four sine waves whose phases each differ by p/2 are supplied to the QPSK modulator 32 from a signal generator 33, and the QPSK modulator 32 selects one of the signals supplied from the signal generator 33 in accordance with the 2-bit information inputted from the convolutional encoder 31.

If the signal inputted from the convolutional encoder 31 is "00", the QPSK modulator 32 selects $\sin 2pf_1t$, if the inputted signal is "10", it selects $\sin (2pf_1t + p/2)$, if it is "11", it selects $\sin (2pf_1t + p)$, and if the inputted signal is "01", the QPSK modulator 32 selects $\sin (2pf_1t + 3p/2)$. The signal selected by the QPSK modulator 32 is guided to a bandwidth filter 34 with a core frequency of $f_1$Hz, and, the bandwidth filter 34, together with the bandwidth filter 44 on the receiving side, regulates the bandwidth using cutoff characteristics that satisfy Nyquist's first criteria for suppressing inter-symbol interference. The core frequency $f_1$Hz, for example, is set at 150kHz. The output of the bandwidth filter 34 is converted by a multiplier 35 to a signal of the desired radio frequency bandwidth, for example, 1.5GHz, and is transmitted via a power amplifier 36 from an antenna 37.

In a receiver 302, a signal received by an antenna 41, subsequent to being amplified by an amplifier 42, is restored to a signal of 150kHz from a signal of 1.5GHz by a frequency converter 43. This signal is guided by way of a bandwidth filter 44 to a QPSK demodulator 45 and carrier wave regenerator 46. An output signal of the QPSK demodulator 45 is also inputted to the carrier wave regenerator 46, which regenerates $\sin (2pf_1t + p/4)$ and $\sin (2pf_1t + 3p/4)$, and outputs them to the QPSK demodulator 45. The QPSK demodulator 45 uses each of these inputted signals to detect coherence. Two coherent detection outputs are guided to a subsequent-stage Viterbi decoder 48. A decoded information bit is outputted from the Viterbi decoder 48 to a terminal 49.

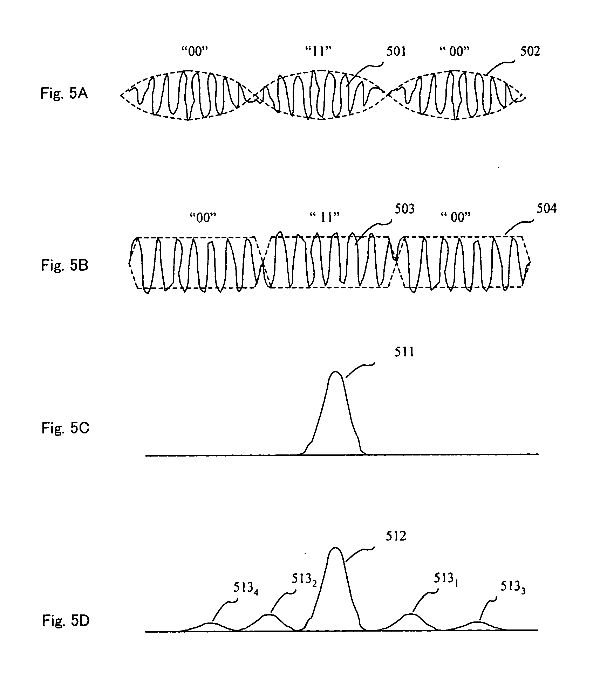

Fig. 5 is simplified diagrams showing signal waveforms and spectrums transmitted from the antenna 37. When the signals inputted to the QPSK modulator 32 from the convolutional encoder 31 are "00", "11", and "00", the signal waveform becomes like the first signal waveform 501 shown in Fig. 5A, and the amplitude drops significantly at the transmission symbol point of change like the first envelope 502. When the input/output characteristics of the power amplifier 36 are linear, the signal waveform transmitted from the antenna 37 maintains the shapes of the first signal waveform 501 and first envelope 502 when sent. The main lobe 511 of this spectrum is a dominant narrow bandwidth spectrum. Therefore, in a mobile communications system, a channel can be set in this frequency band spacing.

However, when the input/output characteristics of the power amplifier 36 are nonlinear, the amplitude of the output signal transmitted from the antenna 37 becomes practically flat at locations other than the transmission symbol point of change, like the second envelope 504 shown in Fig. 5B. The signal waveform itself is also greatly distorted from the original signal waveform, like the second signal waveform 503. The spectrum of this signal, as shown in Fig. 5D, generates numerous side lobes $513_1$, $513_2$, $513_3$, $513_4$, ... in addition to the main lobe 512.

In a mobile communications system, this side lobe spectrum causes problems, such as interference with other channels. Or, if channel spacing is widened to avoid this interference with other channels, the problem is that the number of subscribers capable of talking simultaneously decreases.

To reduce the adverse affects of the nonlinear characteristics of the power amplifier, amplitude variations should be minimized as much as possible. Accordingly, p/4 shift QPSK was developed for the purpose of suppressing QPSK amplitude variations, and is being used in cellular telephone systems. However, because the instantaneous amplitude drops to 38% of the carrier wave amplitude at symbol transition time even when p/4 shift QPSK is utilized, p/4 shift QPSK does not solve for the problem of a side lobe spectrum interfering with other channels when the power amplifier possesses nonlinear characteristics.

Further, there have also been proposals in recent years for constant envelope modulation systems that are not affected by power amplifier nonlinear characteristics. These include Trellis coding 8-phase PSK systems, which combine 8-phase modulation and coding modulation (For example, refer to Literature 5. Ungerboeck, G.: "Channel coding with phase signals," IEEE Trans. Inf. Theory, IT-23, 1, pp. 55-67, Jan. 1982), and systems, which upgraded this system to constant envelope modulation (For example, refer to Literature 6. Tomisato, Suzuki: "Envelope Control-type Digital Modulation System, which Improves Power Efficiency for Transmission Amplification - Applications for Trellis Coding 8-PSK for Mobile Communications," Institute of Electronics, Information and Communications Engineers Journal, B-II, Vol. J75-B-II, No. 12, pp. 912-928, December 1992.).

However, the coding gain of the Trellis coding 8-phase PSK is only around 3dB versus Eb/No. That is, although it surpasses a QPSK system, which does not utilize error correction, by around 3dB, when you take into consideration the fact that the coding gain of a conventional QPSK system that does use error correction is roughly 5.5dB, the error rate characteristics of the Trellis coding 8-phase PSK system are markedly worse than those of conventional systems. This is brought about by the fact that the error rate characteristics of 8-phase PSK on its own are poor. The specific circuit configuration for making this Trellis coding 8-phase PSK a constant envelope has also been reported (For example, refer to Literature 4.) This is a configuration that expands the GMSK technique, which is a well-known technique for converting binary phase modulation to a constant envelope, to 8-phase modulation, but only the details of the circuit configurations differ, in essence, making it the same technique as GMSK. In other words, it only specifically indicates the circuit configuration when configuring constant envelope 8-phase modulation, and has not achieved both constant envelope properties and an outstanding error rate versus Eb/No.

**[0024]** As explained hereinabove, the problem with a digital communication device, which utilizes conventional QPSK or p/4 shift QPSK, is that since modulated wave amplitude variation is great, a waveform is greatly distorted when it passes through a nonlinear amplifier, generating a side lobe spectrum. This brings about the deterioration of spurious characteristics and an increase in the reception signal error rate. Further, since the occupied frequency bandwidth is wide when GMSK, which is a constant envelope modulation system, and error correction are utilized, the problem here is that frequency utilization efficiency becomes poor. Another problem is that Trellis coding constant envelope 8-phase modulation does not produce very favorable error rate characteristics versus Eb/No.

**[0025]** The present invention was devised with the above-mentioned problems in mind, and an object of the present invention is to provide a digital communication device, which has the same bit error rate and occupied radio bandwidth as a digital communication device that uses either conventional QPSK or p/4 shift QPSK in combination with an error correction system, and which is capable of greatly enhancing amplitude variations. And/or an object of the present invention is to provide a digital communication device, which possesses the same constant envelope characteristics as GMSK that uses a conventional error correction code, and is capable of transmitting a signal in a narrower occupied frequency bandwidth.

DISCLOSURE OF THE INVENTION

A communications method of the present invention is characterized in that it performs coding by converting a binary digital information signal to a ternary signal, changes the phase of a carrier wave in response to this coded ternary signal, and transmits a three-phase modulated signal, and a modulator related to a digital communication device of the present invention comprises coding means for converting a binary digital information signal to a ternary signal, and phase modulating means for changing the phase of a carrier wave in response to the ternary signal.

Further, a communications method of the present invention is characterized in that it detects information related to a ternary signal by phase demodulating a phase-modulated signal, and obtains binary digital information by using and decoding information related to a ternary signal obtained by virtue of this phase demodulation, and a demodulator related to a digital communication device of the present invention comprises phase demodulating means for detecting information related to a ternary signal from a received phase modulated wave, and decoding means for determining binary digital information from information related to a ternary signal.

In a digital communication device of the present invention, ternary digital information is generated from a plurality of binary digital information inputted to coding means, and outputted. This ternary digital information is guided to phase modulating means, and is used to determine the phase of a modulated wave. Phase modulating means outputs a three-phase modulated wave. Phase demodulating means, which receives this signal via a communications channel, provides information related to the ternary signal, for example, maximum likelihood information for three signals, to decoding means.

Decoding means estimates the original plurality of binary digital information using a plurality of maximum likelihood information for three signals, and outputs the estimated binary information as a decoded signal. Since the ternary digital information outputted from coding means has redundancy relative to the inputted binary digital information, error tolerance to communication channel noise increases. Further, since the output signal of coding means is ternary digital information, and decoding means inputs maximum likelihood information related to a ternary signal, phase modulating means and phase demodulating means can have three-phase modem functions.

Since the amplitude variation of a three-phase modulated wave at symbol transition time is small, waveform distortion is minimal, and unnecessary side lobe spectra can be minimized even if this phase modulated wave is transmitted via a power amplifier with nonlinear characteristics. Further, even when phase modulating means outputs a constant envelope three-phase modulated wave, the binary digital information can be restored by the same demodulating means. When made into a constant envelope, the occupied frequency band increase slightly more than that of a three-phase modulated wave that is not a constant envelope, but frequency distortion resulting from a nonlinear power amplifier hardly occurs at all, and error tolerance to communication channel noise increases the same as in the case of three-phase modulation, which is not a constant envelope.

BRIEF DESCRIPTION OF THE DRAWINGS

Fig. 1 is a simplified block diagram showing a digital communication device in accordance with the present invention;

Fig. 2 is a block diagram showing a first embodiment of an encoder of the present invention;

Fig. 3 is a block diagram showing a first embodiment of a three-phase demodulator of the present invention;

Fig. 4 is a simplified block diagram showing a digital communication device, which utilizes a conventional convolutional code and QPSK;

Fig. 5 is waveform diagrams and spectrum diagrams for illustrating the effects that the input/output characteristics of a power amplifier exert on a modulated radio signal;

Fig. 6 is symbol transition diagrams for illustrating differences in instantaneous amplitudes of modulated radio signals;

Fig. 7 is a diagram showing the decision area for three-phase modulation;

Fig. 8 is a diagram showing bit error rate characteristics versus Eb/No;

Fig. 9 is a phase transition diagram of a constant envelope three-phase modulated wave in accordance with the present invention;

Fig. 10 is a frequency change diagram of a constant envelope three-phase modulated wave in accordance with the present invention;

Fig. 11 is a simplified block diagram of a constant envelope three-phase modulator of the present invention; and

Fig. 12 is a simplified block diagram of a binary-input/ternary-output convolutional encoder of the present invention.

BEST MODE FOR CARRYING OUT THE INVENTION

A digital communication method and digital communication device of the best mode for carrying out the present invention will be explained hereinbelow using the figures. Below, the aspects of the embodiment of the present invention will be explained in detail while referring to the figures.

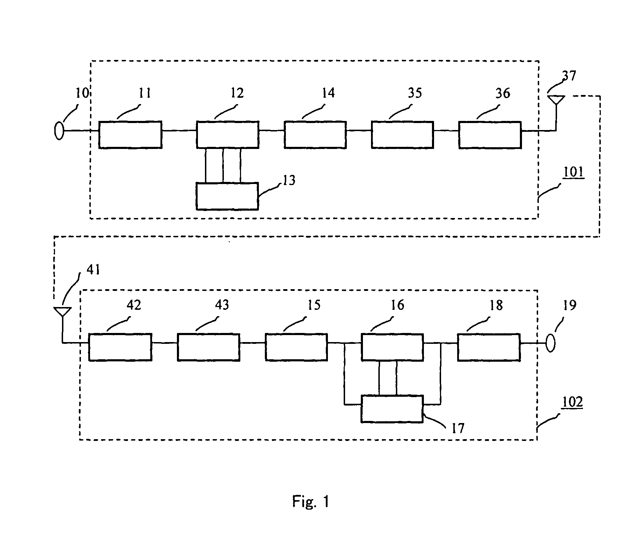

Fig. 1 is a simplified block diagram showing a first embodiment of a digital communication device of the present invention. In a transmitter 101, binary digital information inputted from a terminal 10 is sequentially inputted to an encoder 11. The encoder 11 outputs ternary digital information to a three-phase modulator 12 each time binary digital information is inputted. Sine waves whose phases differ only from one another are supplied from a signal generator 13 to the three-phase modulator 12, and the three-phase modulator 12 selects one of the signals supplied from the signal generator 13 in accordance with the ternary digital information inputted from the encoder 11.

If the signal inputted from the encoder 11 is "0", the three-phase modulator 12 selects $\sin 2pf_1t$, if the inputted signal is "1", it selects $\sin (2pf_1t + 2p/3)$, and if the inputted signal is "2", the three-phase modulator 12 selects $\sin (2pf_1t + 4p/3)$. The signal selected by the three-phase modulator 12 is guided to a bandwidth filter 14 having a core frequency of $f_1$Hz, and the bandwidth filter 14, together with the bandwidth filter 15 on the receiving side, regulates the bandwidth using cutoff characteristics that satisfy the Nyquist criterion for suppressing inter-symbol interference. The core frequency $f_1$Hz, for example, is set at 150kHz. The output of the bandwidth filter 14 is converted by a multiplier 35 to a signal of the desired radio frequency band, for example, 1.5GHz, and is transmitted via a power amplifier 36 from an antenna 37.

In a receiver 102, a signal received by an antenna 41, subsequent to being amplified by an amplifier 42, is restored to a signal of the 150kHz band from a signal of the 1.5GHz band by a frequency converter 43. This signal is guided by way of a bandwidth filter 15 to a three-phase demodulator 16 and carrier wave regenerator 17. An output signal of the three-phase demodulator 16 is also inputted to the carrier wave regenerator 17, which regenerates $\sin 2pf_1t$ and $\sin (2pf_1t + p/2)$, and outputs them to the three-phase demodulator 16.

The carrier wave regenerator 17 can be readily constituted using a known technique utilizing, for example, a Costas loop. The three-phase demodulator 16 uses $\sin 2pf_1t$ and $\sin (2pf_1t + p/2)$ to demodulate a signal guided from the bandwidth filter 15. For example, log likelihoods for three phases are outputted from the three-phase demodulator 16, and guided to a decoder 18. The decoder 18 utilizes the log likelihoods to decode binary digital information, and outputs it to an output terminal 19. Digital communications can be carried out in this way.

The bit error rate versus Eb/No in accordance with the present invention will be explained.

The bit error rate versus Eb/No of BPSK and QPSK in a white Gaussian noise communication channel, as is well known, is rendered as

$$\varepsilon_2(\alpha) = \frac{1}{2} \, \mathrm{erfc}\left(\sqrt{\alpha/2}\right) = \frac{1}{\sqrt{\pi}} \int_{\sqrt{\alpha/2}}^{\infty} e^{-t^2} dt \qquad \cdots (1)$$

Here, a = Eb/No. In relation to this, in the case of three-phase modulation related to the present invention, the error rate is determined as described hereinbelow.

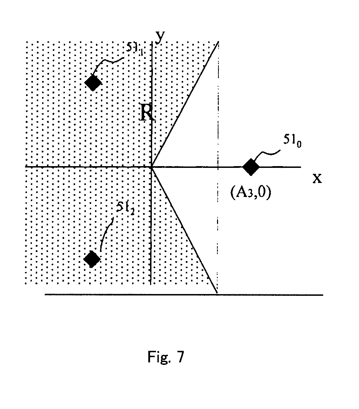

Fig. 7 shows the decision area of three-phase modulation expressed as a phase plane. When signal point 510 is transmitted, if it is received in the diagonal area R, it will be mistakenly demodulated. This error rate e is rendered as:

$$\varepsilon = 1 - \iint_{(x,y)\in R} \frac{1}{2\pi\sigma^2} e^{-\frac{(x-A_3)^2}{2}} e^{-\frac{y^2}{2}} dxdy \qquad \cdots (2)$$

Here, transmission power is $A_3^2/2$ and noise power is $\sigma^2$. Furthermore, A is the amplitude of the carrier wave. Taking into consideration the fact that with three-phase modulation, $\log_2 3$ bits can be transmitted using one symbol, and the fact that the shortest distance to area R from signal point 510 in Fig. 7 is $\sqrt{3} \cdot A_3/2$, the bit error rate versus Eb/No of three-phase modulation is determined as follows:

$$\frac{1}{2} \, \mathrm{erfc}\,(1.09\,\sqrt{\alpha/2}\,) < \varepsilon_3 < \mathrm{erfc}\,(1.09\,\sqrt{\alpha/2}\,) \tag{3}$$

To date, of the stand-alone digital modulation schemes that do not use error correction, BPSK and QPSK have been considered the best for Eb/No versus bit error rate characteristics. However, strict analysis of Equation (2) shown above clearly showed that the error rate performance of the three-phase modulation utilized in the present invention surpassed that of QPSK at Eb/No of 4.86dB or higher. This improvement effect becomes larger as the value of Eb/No becomes larger, and based on Equation (3), this characteristic is asymptotic to the characteristic whereby Eb/No is 0.7db better than QPSK. Thus, it is clear that the bit error rate characteristics versus Eb/No of the three-phase modulation related to the present invention is extremely outstanding even when used alone.

Next, amplitude variation in accordance with the present invention will be explained. The amplitude variation of a signal inputted via a power amplifier 36 can be improved significantly in accordance with the present invention compared to that of conventional QPSK and p/4 shift QPSK.

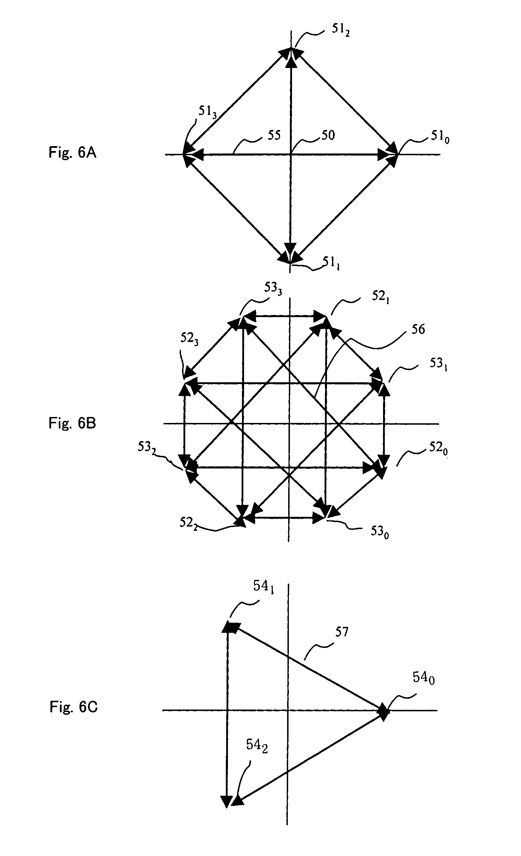

Fig. 6 is symbol transition diagrams plotted on a carrier wave frequency phase plane to illustrate the magnitude of amplitude variations. Fig. 6A is a QPSK symbol transition diagram, and each time a symbol is transmitted, it transitions reciprocally between four signal points $51_0$, $51_1$, $51_2$, $51_3$. Just like when the symbol transitions from signal point $51_0$ to signal point $51_3$, when the phase transitions between signal points that only differ by p, this transition locus 55 passes through the point of origin 50. On a phase plane, the instantaneous amplitude value of the amplitude is expressed as the distance to the transition locus from the point of origin. Therefore, as explained above, when the phase transitions between signal points that only differ by p, the amplitude drops to zero at symbol transition time.

Fig. 6B is a p/4 shift QPSK symbol transition diagram, and each time a symbol is inputted, the signal points capable of being occupied change. That is, when any of the four signal points 520, 521, 522, 523 are occupied relative to a symbol input at a certain time, any of the four signal points 530, 531, 532, 533 will be occupied relative to the next symbol input. In addition, any of the four signal points 520, 521, 522, 523 will be occupied relative to the symbol input subsequent to that. The minimum value of the distance from the point of origin to the transition locus 56 is improved over that of QPSK, but even so, that is still only 38% of the distance from the point of origin to a signal point. Thus, the change in the instantaneous amplitude value of the amplitude is as large as before.

By contrast to this, in the symbol transition diagram of the present invention shown in Fig. 6C, symbols transition reciprocally between three signal points 540, 541, 542, and the minimum value of the distance between the point of origin and the transition locus 57 is greatly improved to 50% of the distance from the point of origin to the signal point. That is, the minimum value of the instantaneous amplitude is improved approximately 1.3-fold that of the p/4 shift QPSK scheme. As a result of this, even if a power amplifier 36 has nonlinear characteristics, it is still possible to greatly reduce the generation of an unnecessary side lobe spectrum.

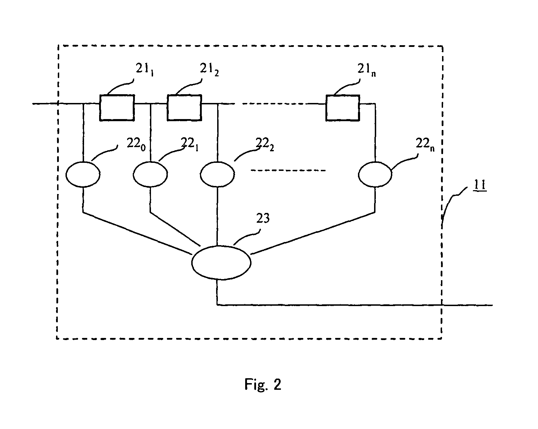

Fig. 2 is a simplified block diagram showing a more detailed first embodiment with regard to the encoder 11. Binary digital information of either "0" or "1" is guided from the input terminal 10, and is sequentially inputted to shift registers $21_1$, $21_2$, ..., $21_n$. The respective output signals of shift registers $21_1$, $21_2$, ..., $21_n$ are guided to coefficient multipliers $22_0$, $22_1$, $22_2$, ..., $22_n$ over a modulo 3 Galois field, the coefficients are multiplied, and guided to a modulo 3 adder 23. A ternary signal comprising the signals "0", "1", "2" is outputted from the adder 23. Furthermore, when the multiplied coefficients are 0, this coefficient multiplier can be omitted. Further, since the output signals of the shift registers $21_1$, $21_2$, ..., $21_n$ are binary values, only two elements can be captured inside a ternary signal, and when these two elements are treated as a zero element and a unit element, the coefficient multiplier can be easily constituted using a selector circuit for selecting either a coefficient value or a 0 in accordance with a shift register signal.

However, the encoder shown in Fig. 2 is the same as the encoder proposed for the above-mentioned magnetic recording system (Literature 3), and the only thing disclosed in Literature 3 is that a connection is selected so that the post-decoding error rate becomes small, but nothing was made clear with regards to a specific connection method or its characteristics. When the constraint length of the convolutional code becomes long, measuring the error rate for all connection combinations is extremely difficult.

In a 3-value magnetic recording system, because the probability of an error occurring from the 0 level to another level is greater than the error rate of the other two levels, the error rate subsequent to decoding must be measured in order to stipulate the optimum connection method. By contrast to this, in the three-phase modulation utilized in the present invention, since the error rates for three symbols are equivalent, the optimum connection method can be determined by doing a computer search for the connection method having the smallest free distance. Therefore, the quality of a convolutional code can be evaluated in accordance with the smallest free distance.

The convolutional code utilized here can be called an encoder for a special class of convolutional codes. In the past, the input signal field and output signal field of an ordinary convolutional code coincided. By contrast, in the convolutional code generated by the encoder of Fig. 2 related to the present invention, the input has an element over a modulo 2 Galois field, that is GF (2), and the output has an element over GF(3). Or, the convolutional code can also be called one in which the input is limited to a specific element over GF(3). A convolutional code that is limited like this differs greatly from the ordinary convolutional codes and their properties that have been known for some time now.

As a result of using a computer search to determine the smallest free distance, it became clear that the properties [of the convolutional code of the present invention] differ from those of an ordinary convolutional code. In a conventional convolutional code over GF(3), if the coding rate is set at 1, the smallest free distance will always be 2 or less no matter how long the constraint length is. By contrast, with the convolutional code related to the present invention, there are instances when the smallest free distance will increase when the constraint length is made longer. However, the smallest free distance does not get longer if the constraint length is made longer as it does with a conventional convolutional code. More specifically, it is possible to constitute a code by which the smallest free distance becomes 6 when the constraint length is set at 7. However, if the constraint length is set to 8, the smallest free distance decreases instead. The connection method for the convolutional code can be described as a generating function, and the connection methods, that is, the generating functions for making the smallest free distance 6 when the constraint length is 7, are limited to two:

$$g(D) = 1 + 2D + D^2 + D^4 + D^5 + D^6 \qquad (4)$$

or

$$g(D) = 2 + D + 2D^2 + 2D^4 + 2D^5 + 2D^6 \qquad (5)$$

When the constraint length is an even number, most often the code becomes catastrophic in that once an error occurs, it is propagated without being automatically recoverable, making it impractical. These characteristics are caused by a special condition in which the symbol coding rate is 1.

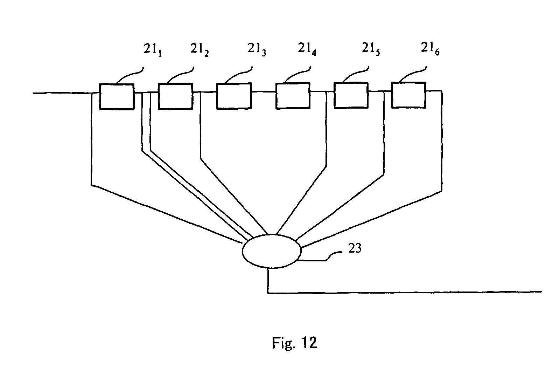

Fig. 12 is a more specific block diagram of a binary-input/ternary-output convolutional encoder. The generating function of this convolutional encoder is given by Equation (4). Here, D represents a delay element, and the coefficient represents the multiplication coefficient of this delay element. Further, the add symbol signifies modulo-3 addition. Binary digital information guided from a terminal 10 is time delayed by a six-stage shift register $21_1$, $21_2$, ..., $21_6$.

An input signal and output signals of the shift register second stage $21_2$, fourth stage $21_4$, fifth stage $21_5$, and sixth stage $21_5$ are guided to an adder 23 in accordance with the generating function. The output of the first stage $21_1$ of the shift register must be doubled before it can be added, but if the same signal is added twice, the multiplier can be omitted. For this reason, the output signal of the first stage $21_1$ of the shift register is guided to the adder 23 two times. The adder 23 is a modulo-3 adder, and the result of addition is outputted as a ternary signal.

When the encoder shown in Fig. 2 is used, the decoder 18 in the receiver 102 can utilize a Viterbi decoder. When the number of stages of the encoder 11 shift register is n, the number of states of the Viterbi decoder is 2n despite the fact that the code word of the convolutional code is a ternary signal. When decoding a conventional convolutional code over GF(3), the number of states of the Viterbi decoder was 3n. Because the circuitry and the number of states of a Viterbi decoder are practically proportional, the circuitry of a Viterbi decoder for decoding a convolutional code related to the present invention is much simpler than in the past. For example, if a convolutional code of constraint length 7 is used as an example, since the value of n is 6, the number of states in Viterbi decoding, that is the size of the circuit, is less than 1/11th of a conventional Viterbi decoder.

The outstanding points of the embodiment of Fig. 2 are the fact that the values of the bit rate of inputted binary digital information and the baud rate of digital phase modulation are the same and the occupied frequency bandwidth thereof is narrow; the fact that there are no time delays associated with coding because one ternary signal is outputted every time one bit of binary digital information is inputted; and the fact that excellent bit error rate characteristics can be achieved.

However, an encoder of the present invention is not limited to the embodiment of Fig. 2, and can be changed in various ways. In the embodiment of Fig. 2, one ternary signal is outputted for every one bit of binary digital information that is inputted, but this coding rate is the same as that of an ordinary convolutional code, and can be changed at will. For example, if the constitution is made such that two ternary signals are outputted for every one bit of binary digital information that is inputted, it will be possible to greatly increase the minimum free distance under the same constraint length. However, the transmission channel baud rate will double.

Further, in the embodiment of Fig. 2, an encoder 11 generates a convolutional code, but it could also be constituted so as to generate a clock code. In this case, h ternary signals will be outputted for k binary digital information. However, k and h will be set such that 3h is greater than 2k. If k and h are the same value, the average bit rate and the average baud rate can be made to coincide. If a selection is made such that an encoder 11 is inputted with binary digital information and outputs ternary signals, any constitution is fine. And then, when this output signal is constituted so as to become an error correction code, it will be possible to provide a digital communication device for which bit error rate characteristics versus Eb/No is outstanding. Further, if a selection is made such that the number of outputted ternary signals constitutes the integral multiple of the number of inputted binary digital information, the delay time of the encoder 11 can be reduced. In particular, when a convolutional code that outputs an integral number of ternary signals each time one binary digital information is inputted, it will be possible to provide a digital communication device having special advantages, such as no delay pursuant to coding, and the realization of outstanding error rate characteristics.

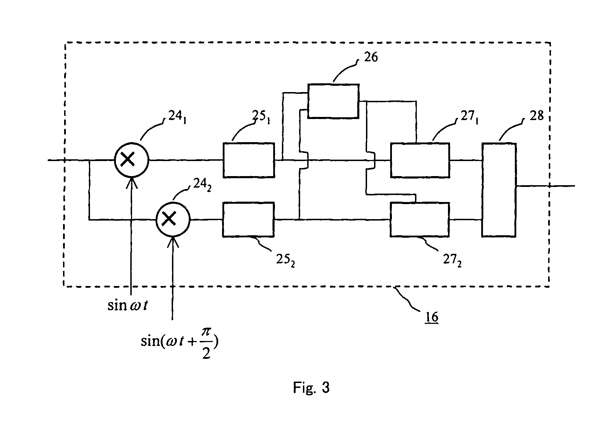

Fig. 3 is an embodiment with a more detailed three-phase demodulator 16. A 150 kHz band signal, which is inputted from a frequency converter 43, is guided to a multiplier $24_1$ and a multiplier $24_2$. A carrier wave regenerator 17 supplies $\sin 2pf_1t$ to multiplier $24_1$, and similarly, supplies $\sin (2pf_1t + p/2)$ to multiplier $24_2$. The high-frequency components of the output signals of multiplier $24_1$ and multiplier $24_2$ are removed by a low-pass filter $25_1$ and a low-pass filter $25_2$, respectively. Thus, coherent detection of in-phase components and quadrature components is carried out.

The output signals of low-pass filter $25_1$ and low-pass filter $25_2$ are respectively guided to a bit timing extraction circuit 26, and are also guided to an AD converter $27_1$ and an AD converter $27_2$. In the AD converter $27_1$ and the AD converter $27_2$, the input signals are sampled at a timing specified from the bit timing extraction circuit 26, converted from analog to digital, and outputted.

These two output signals are guided to a maximum likelihood computation circuit 28, and the maximum likelihoods for three signal points are computed and outputted. Here, maximum likelihood computations in the maximum likelihood computation circuit 28 are carried out as follows. The output signal of the AD converter $27_1$ represents the size of an in-phase component. This value is treated as x. Similarly, the output signal of the AD converter $27_2$ represents the size of a quadrature component. This value is treated as y. When the noise added by the communication channel is Gaussian noise, the probability density function of a reception signal constitutes a two-dimensional Gaussian function that treats the coordinates of the transmitted signal points as an average value. That is, the maximum likelihood of the respective signal points when x and y are obtained can be determined as a probability density for the points (x, y) of a signal point-based two-dimensional Gaussian function. The logarithm of this probability density value is determined, and deleting the absolute terms common to the three signal points produces log likelihoods. If the three signal points 540, 541, 542 shown in Fig. 6C are utilized, the log likelihood for signal point 540 is 2x, the log likelihood for signal point 541 is $(-x + \sqrt{3}\,y)$, and the log likelihood for signal point 542 is $(-x - \sqrt{3}\,y)$. In other words, [log likelihoods] can be easily calculated from the outputs of AD converter $27_1$ and AD converter $27_2$. Further, when making strict decisions vice log likelihoods, signal points that take maximum values compared to the above-mentioned log likelihoods can be used as reception signals.

Next, a digital communication device related to the present invention, which utilizes a ternary convolutional encoder of constraint length 7 and a three-phase modulator will be comprehensively compared against a conventional digital communication device that uses a conventional convolutional code of constraint length 7 and p/4 shift QPSK.

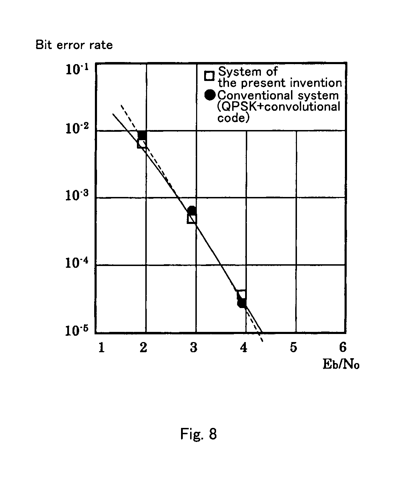

Fig. 8 shows the bit error rate characteristics versus Eb/No for these two systems. As is clear from this diagram, the error rate characteristics are practically the same. Further, since the same constraint length of 7 is used for the convolutional codes, the size of the decoding circuits is also practically the same. In other words, while a digital communication device related to the present invention that makes use of a constraint length of 7, a ternary convolutional encoder of coding rate 1, and a three-phase modulator has the same main lobe radio occupied bandwidth, the same device circuitry size, and practically the same error rate characteristics versus Eb/No as a conventional digital communication device that utilizes a constraint length of 7, a binary convolutional code of coding rate 1/2, and p/4 shift QPSK, the amount of instantaneous amplitude variation [in the digital communication device of the present invention] can be enhanced approximately 30%.

An especially important point here is that the three-phase modulation and binary-input/ternary-output error correction code related to the present invention mutually supplement each other's pros and cons. The instantaneous amplitude variation characteristics and error rate characteristics versus Eb/No of the three-phase modulation related to the present invention clearly surpass those of QPSK as basic properties thereof. However, the compatibility of three-phase modulation with binary digital information was problematic. Conversely, with regard to the error correction system, the coding gain of the binary-input/ternary-output error correction code is slightly inferior to the coding gain of a coding rate 1/2 convolutional code of the same constraint length. However, it is possible to completely resolve the compatibility of symbol conversion between binary digital information and three-phase modulation. In addition, the slight inferiority of the coding gain of the error correction code itself can be offset by the favorable error rate characteristics versus Eb/No that the three-phase modulation possesses. As a result, there remains the advantage of being able to improve instantaneous amplitude characteristics with equal error rate characteristics. Thus, in accordance with the pros and cons of three-phase modulation and binary-input/ternary-output error correction code mutually supplementing each other, it is possible to constitute a digital communication device with characteristics that are outstanding overall.

Therefore, even if a binary-input/ternary-output error correction code is utilized with a recording system that uses three magnetism or voltage values, like well-known magnetic recording systems (Literature 3), or with a modulation system that utilizes a three-value ASK (amplitude shift keying) method in which the demodulation voltage constitutes three values, the error rate characteristics versus Eb/No are considerably inferior to those of a conventional systems that utilizes QPSK and a convolutional code, and effects like those with the present invention are not achieved.

Furthermore, the present invention is not limited to the embodiment described hereinabove, and various changes can be made to this embodiment. For example, in the embodiment of Fig. 1, the minimum value of the instantaneous amplitude was 50% of the maximum amplitude, but this can be changed to amplitude variation-free constant envelope modulation.

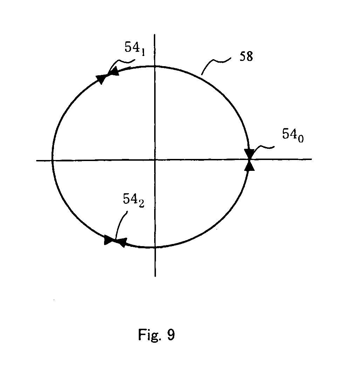

Fig. 9 is a phase transition diagram of a digital communication device related to the present invention, which utilizes constant envelope three-phase modulation. In constant envelope three-phase modulation, phase points transition by tracking along a transition locus 58 between the three phase points $54_0$, $54_1$, $54_2$ shown in Fig. 9. In Fig. 9, when the signal point moves in the counter-clockwise direction from phase point $54_0$ to phase point $54_1$, or from phase point $54_1$ to phase point $54_2$, or from phase point $54_2$ to phase point $54_0$, that is, when the phase increases, the instantaneous frequency becomes higher. Conversely, when the signal point moves in the clockwise direction as from phase point $54_1$ to phase point $54_0$, the instantaneous frequency decreases.

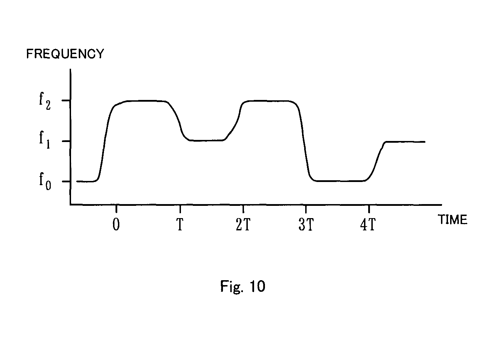

Fig. 10 shows the time variation of this instantaneous frequency. To suppress the spread of a modulated wave side spectrum, it is necessary to move the transition locus 58 such that the primary differential coefficient becomes continuous in an instantaneous frequency variation diagram.

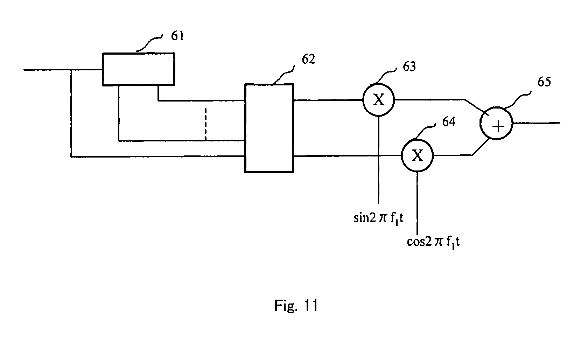

Fig. 11 shows a simplified block diagram of a constant envelope three-phase modulator. If the three-phase modulator 12 and signal generator 13 in Fig. 1 are replaced with the circuit of Fig. 11, a constant three-phase modulated wave is achieved. This wave is constituted by expanding a conventional GMSK wave generation method to three values. A ternary signal guided from the encoder 11 is inputted to a delay circuit 61 and a waveform data storage circuit 62. A signal inputted to the delay circuit 61 delays the timing, and, for example, supplies signals for the past four time slots to the waveform data storage circuit 62. Therefore, a ternary signal of several consecutive symbols is inputted to the waveform data storage circuit 62. Since the original value corresponds to a phase, the ternary signal is also phase data.

The response waveform of the Fig. 9 transition locus 58 at the time the phase data of these several symbols is inputted, more specifically, the in-phase component and quadrature component of the response waveform of the transition locus 58 are stored in the waveform data storage circuit 62. As for the output waveform of the waveform data storage circuit 62, $\sin 2pf_1 t$ and $\sin (2pf_1 t + p/2)$ are multiplied in multiplier 63 and multiplier 64, respectively, and synthesized in adder 65. The actions of multiplier 63, multiplier 64, and adder 65 signify that the two signals outputted from the waveform data storage circuit 62 orthogonally modulate a carrier wave. Since the signals supplied from waveform data storage circuit 62 to the multipliers 63, 64 are values on the transition locus 58, the signal outputted from the adder 65 constitutes a constant envelope modulated wave.

Here, a waveform stored in the waveform data storage circuit 62 is a waveform, which corresponds to time variations of an instantaneous frequency when the phase data of several symbols are inputted, but the interpretation of instantaneous frequency time variations has not been uniformly determined.

In conventional GMSK, a Gaussian filtered response waveform of an instantaneous frequency corresponding to several symbols of a binary signal is utilized, but the spread of spectral side lobes can be suppressed even when a Gaussian filtered response waveform of an instantaneous frequency corresponding to several symbols of a ternary signal is utilized in the present invention.

Because an arbitrary waveform can be stored in the waveform data storage circuit 62, a waveform other than a Gaussian filtered response waveform can also be used. An output signal of the adder 65 is outputted to a bandpass filter 14. For a modulated waveform achieved in this manner, there is no drop in instantaneous amplitude, and its envelope is constant. For this reason, even if transmission is made via a power amplifier for which input-output characteristics are nonlinear, the spectrum is hardly affected at all. The result is that power amplifier power consumption can be held in check more than when a linear modulated wave is used as in QPSK, making it possible to use a mobile terminal for a longer period of time with the same battery capacity.

Constant envelope three-phase modulation in accordance with the present invention has a marked advantage over a conventional system that utilizes an error correction system and GMSK. The occupied bandwidth of a constant envelope three-phase modulated wave related to the present invention is 1.33 times that of GMSK alone. This is because, whereas the amount of phase transition between symbols is p/2 for GMSK, for constant envelope three-phase modulation it increases to a maximum of 2p/3, thereby increasing the phase variation rate per unit time 1.33 fold.

However, because the binary-input/ternary-output encoder utilized in the present invention has error correction capabilities, the error rate versus Eb/No is excellent. In order to achieve the same error rate using GMSK as that of constant envelope three-phase modulation utilizing the encoder shown in Fig. 2, it is necessary to utilize a coding rate 1/2 convolutional code similar to the case of QPSK. Since the GMSK symbol rate is double the information bit rate at this time, two times the radio frequency bandwidth of GMSK alone is needed. As a result, when using constant envelope three-phase modulation related to the present invention, the occupied frequency bandwidth can be reduced to 2/3 that of a system that utilizes a conventional convolutional code and GMSK having the same constant envelope properties and practically the same error rate characteristics versus Eb/No. In other words, if the usable frequency bandwidth is the same, using the present invention makes it possible to increase the number of people that can converse simultaneously by 1.5 fold.

Furthermore, in the above explanation, the present invention is described using a digital communication device, but the present invention can be applied to a digital storage device. Whereas digital communications is carried out by modulating and demodulating digital information such as voice, images and so forth via a communications medium, digital storage is carried out by modulating and demodulating digital information via a storage medium, and [these two applications of the present invention] have the fact in common that modulation and demodulation are carried out via a medium.

For example, in a magnetic recording device, when digital information is recorded by linearly converting it to either a record or a high frequency, the same effect can be achieved by treating the magnetic recording medium the same as a communication channel, making it possible to apply the present invention to the realization of multiple channels and high density.

As described in detail hereinabove, in accordance with the present invention, it is possible to greatly improve the amount of variation of instantaneous amplitude in a modulated wave without sacrificing any main lobe radio frequency occupied bandwidth, device circuit size, or error rate characteristics versus Eb/No compared to a digital communication device that utilizes a conventional error correction system and QPSK. As a result of this, the generation of a side lobe spectrum can be held in check, and interference with adjacent channels can be greatly reduced even when using a power amplifier with nonlinear input-output characteristics.

Further, because there are few side lobe spectrums, frequency spacing between adjacent channels can be reduced, making it possible to strive for increased subscriber capacity. Further, if constant envelope three-phase modulation in accordance with the present invention is utilized, it is possible to reduce occupied frequency bandwidth to 2/3 that of a digital communication device that utilizes a conventional error correction system and GMSK without sacrificing device circuit size, or error rate characteristics versus Eb/No, and while maintaining constant envelope characteristics, which are not affected by a power amplifier with nonlinear input-output characteristics.

INDUSTRIAL APPLICABILITY

A digital communication method and digital communication device of the present invention is also ideal for a mobile communication system.

**Claims**

1. A digital communication method, **characterized in that** a binary digital information signal is converted to a ternary signal and encoded, the phase of a carrier wave is changed in response to the encoded ternary signal, and the three-phase modulated signal is transmitted.

2. A digital communication method, **characterized in that** information related to a ternary signal is detected by phase demodulating a phase-modulated signal, and binary digital information is obtained by carrying out decoding using the information related to the ternary signal obtained by the phase demodulation.

3. A digital communication device, **characterized in** comprising:

   encoding means for converting binary digital information to a ternary signal; and
   three-phase modulating means for changing the phase of a carrier wave in response to a ternary signal outputted from the encoding means.

4. A digital communication device, **characterized in** comprising:

   phase demodulating means for detecting information related to a ternary signal from a phase modulated signal; and
   decoding means for determining binary digital information using information related to a ternary signal outputted from the phase demodulating means.

5. The digital communication device according to Claim 3, **characterized in that** said encoding means comprises ternary signal encoding means which comprises:

   delaying means for delaying binary digital information; and
   means for carrying out an operation over a Galois field GF(3) on a signal outputted from the delaying means.

6. The digital communication device according to Claim 3, **characterized in that** said encoding means comprises:

means for generating, from binary digital information, an error correction code prescribed over a Galois field GF(3); and

three-phase modulating means for changing the phase of a carrier wave in response to a symbol of said error correction code.

**7.** The digital communication device according to Claim 3, **characterized in that** said three-phase modulating means comprises means for generating, in response to a ternary signal outputted from said encoding means, a constant envelope modulated wave having signal points, the phases of which differ relatively by 2p/3 each.

**8.** The digital communication device according to Claim 7, **characterized in that** said constant envelope modulated wave generating means generates, in response to two temporally consecutive symbols, a constant envelope modulated wave, the carrier wave phases of which are either the same or differ relatively by 2p/3.

**9.** A constant envelope three-phase modulator, **characterized in** comprising:

means for delaying or storing a ternary signal;

response waveform storing means for outputting a quadrature component and an in-phase component corresponding to a transition locus of a carrier wave phase in accordance with patterns of a plurality of temporally consecutive ternary signals; and

means for orthogonally modulating a carrier wave using a quadrature component and an in-phase component outputted from the response waveform storing means.

**10.** The digital communication device according to Claim 7 or Claim 8, **characterized in that** said constant envelope modulated wave generating means is a constant envelope three-phase modulator comprising:

means for delaying or storing a ternary signal;

response waveform storing means for outputting a quadrature component and an in-phase component corresponding to a transition locus of a carrier wave phase in accordance with patterns of a plurality of temporally consecutive ternary signals; and

means for orthogonally modulating a carrier wave using a quadrature component and an in-phase component outputted from the response waveform storing means.

**11.** A ternary signal encoder, **characterized in** comprising:

an even number of delaying means for delaying binary digital information; and

means for carrying out an operation over a Galois field GF(3) on a signal outputted from the delaying means and an input signal,

the ternary signal encoder using at least the input signal and final delaying means in an operation over the Galois field GF(3).

**12.** The digital communication device according to any of Claim 3, Claim 5 or Claim 6, **characterized in that** said encoding means comprises:

an even number of delaying means for delaying binary digital information; and

means for carrying out an operation over a Galois field GF(3) on a signal outputted from the delaying means and an input signal,

the digital communication device being a ternary signal encoder which uses at least the input signal and final delaying means in an operation over the Galois field GF(3).

**13.** A convolutional encoder, **characterized in that** a generating function generates, relative to a binary input signal, a convolutional code prescribed by either

$$g(D) = 1 + 2D + D^2 + D^4 + D^5 + D^6$$

or

$$g(D) = 2 + D + 2D^2 + 2D^4 + 2D^5 + 2D^6.$$

14. The digital communication device according to any of Claim 3, Claim 5 or Claim 6, **characterized in that** said three-phase modulating means is a convolutional encoder in which a generating function generates, relative to a binary input signal, a convolutional code prescribed by either

$$g(D) = 1 + 2D + D^2 + D^4 + D^5 + D^6$$

or

$$g(D) = 2 + D + 2D^2 + 2D^4 + 2D^5 + 2D^6.$$

15. A digital storage device, **characterized in** comprising:

means for generating, from binary digital information, an error correction code prescribed over a Galois field GF(3); and
three-phase modulating means for changing the phase of a carrier wave in response to a symbol of said error correction code.

16. A digital storage device, **characterized in** comprising a constant envelope three-phase modulator, which comprises:

means for delaying or storing a ternary signal;
response waveform storing means for outputting a quadrature component and an in-phase component corresponding to a transition locus of a carrier wave phase in accordance with patterns of a plurality of temporally consecutive ternary signals; and
means for orthogonally modulating a carrier wave using a quadrature component and an in-phase component outputted from the response waveform storing means.

17. A digital storage device, **characterized in** comprising a ternary signal encoder, which comprises an even number of delaying means for delaying binary digital information; and means for carrying out an operation over a Galois field GF(3) on a signal outputted from the delaying means and an input signal, and uses at least the input signal and final delaying means in an operation over the Galois field GF(3).

18. A digital storage device, **characterized in** comprising a convolutional encoder in which a generating function generates, relative to a binary input signal, a convolutional code prescribed by either

$$g(D) = 1 + 2D + D^2 + D^4 + D^5 + D^6$$

or

$$g(D) = 2 + D + 2D^2 + 2D^4 + 2D^5 + 2D^6.$$

**Amended claims under Art. 19.1 PCT**

Amendment Claims [Received by the International Bureau on March 9, 2004 (09.03.04): Claims 1 through 7, 11 through 15, 17 and 18 of the initial application were amended; the other Claims are unchanged. (Page 4)]

1. (Amended) A digital communication method, **characterized in that** a binary digital information signal is made into a multivalued ternary signal by means of binary-input/ternary-output error correction code conversion, and is encoded, the phase of a carrier wave is changed and subjected to three-phase modulation in response to the multivalued and encoded ternary signal, and the three-phase modulated signal is transmitted.

**2.** (Amended) A digital communication method, **characterized in that** information related to a ternary signal is detected from a binary-input/ternary-output error correction code by phase demodulating a three-phase modulated signal, and binary digital information is obtained by decoding the binary-input/ternary-output error correction code using information related to the ternary signal obtained by the phase demodulation.

**3.** (Amended) A digital communication device, **characterized in** comprising:

encoding means for multivaluing a binary digital information signal to obtain a ternary signal by means of binary-input/ternary-output error correction code conversion, and encoding [the binary digital information signal]; and

three-phase modulating means for changing the phase of a carrier wave in response to a ternary signal outputted from the encoding means.

**4.** (Amended) A digital communication device, **characterized in** comprising:

phase demodulating means for detecting information related to a ternary signal from a binary-input/ternary-output error correction code by phase demodulating a three-phase modulated signal; and

decoding means for determining a binary digital information signal by decoding a binary-input/ternary-output error correction code using information related to a ternary signal outputted from the phase demodulating means.

**5.** (Amended) The digital communication device according to Claim 3, **characterized in that** said encoding means comprises:

delaying means for delaying a binary digital information signal; and

modulo 3 adding means for carrying out an operation over a Galois field GF(3) on a plurality of signals outputted from the delaying means.

**6.** (Amended) The digital communication device according to Claim 3, **characterized in that** said encoding means generates, from a binary digital information signal, an error correction code prescribed over a Galois field GF(3), and said three-phase modulating means changes the phase of a carrier wave in response to a symbol of said error correction code symbol.

**7.** (Amended) The digital communication device according to Claim 3, **characterized in that** said three-phase modulating means comprises constant envelope modulated wave generating means for generating, in response to a ternary signal outputted from said encoding means, a constant envelope modulated wave having signal points, the phases of which differ relatively by 2p/3 each.

**8.** The digital communication device according to Claim 7 , **characterized in that** said constant envelope modulated wave generating means generates, in response to two temporally consecutive symbols, constant envelope modulated waves, the carrier wave phases of which are either the same or differ relatively by 2p/3.

**9.** A constant envelope three-phase modulator, **characterized in** comprising:

means for delaying or storing a ternary signal;

response waveform storing means for outputting a quadrature component and an in-phase component corresponding to a transition locus of a carrier wave phase in accordance with patterns of a plurality of temporally consecutive ternary signals; and

means for orthogonally modulating a carrier wave using a quadrature component and an in-phase component outputted from the response waveform storing means.

**10.** The digital communication device according to Claim 7 or Claim 8, **characterized in that** said constant envelope modulated wave generating means is a constant envelope three-phase modulator which comprises:

means for delaying or storing a ternary signal;

response waveform storing means for outputting a quadrature component and an in-phase component corresponding to a transition locus of a carrier wave phase in accordance with patterns of a plurality of temporally consecutive ternary signals; and

means for orthogonally modulating a carrier wave using a quadrature component and an in-phase component outputted from the response waveform storing means.

**11.** (Amended) A binary-input/ternary-output error correction encoder, **characterized in** comprising:

an even number of delaying means for delaying an input signal of a binary digital information signal; and modulo 3 adding means for carrying out an operation over a Galois field GF(3) on a signal outputted from the delaying means and an input signal,
the binary-input/ternary-output error correction encoder using at least the input signal and final delaying means output signal in an operation over the Galois field GF (3).

**12.** (Amended) The digital communication device according to any of Claims 3, 5 or 6, **characterized in that** said encoding means is a binary-input/ternary-output error correction encoder, which comprises an even number of delaying means for delaying an input signal of a binary digital information signal, and means for carrying out an operation over a Galois field GF(3) on a signal outputted from the delaying means and an input signal, and uses at least the input signal and final delaying means output signal in an operation over the Galois field GF(3).

**13.** (Amended) A binary-input/ternary-output error correction encoder, **characterized in that** a generating function generates, with respect to a binary input signal, a ternary output error correction code prescribed by either

$$g(D) = 1 + 2D + D^2 + D^4 + D^5 + D^6$$

or

$$g(D) = 2 + D + 2D^2 + 2D^4 + 2D^5 + 2D^6.$$

**14.** (Amended) The digital communication device according to any of Claims 3, 5 or 6, **characterized in that** said three-phase modulating means is a binary-input/ternary-output error correction encoder in which a generating function generates, with respect to a binary input signal, a ternary output error correction code prescribed by either

$$g(D) = 1 + 2D + D^2 + D^4 + D^5 + D^6$$

or

$$g(D) = 2 + D + 2D^2 + 2D^4 + 2D^5 + 2D^6.$$

**15.** (Amended) A digital storage device, **characterized in** comprising:

encoding means for generating, from a binary digital information signal, an error correction code prescribed over a Galois field GF(3); and
three-phase modulating means for changing the phase of a carrier wave in response to a symbol of said error correction code.

**16.** A digital storage device, **characterized in** comprising a constant envelope three-phase modulator which comprises:

means for delaying or storing a ternary signal;
response waveform storing means for outputting a quadrature component and an in-phase component corresponding to a transition locus of a carrier wave phase in accordance with patterns of a plurality of temporally consecutive ternary signals; and
means for orthogonally modulating a carrier wave using a quadrature component and an in-phase component outputted from the response waveform storing means.

**17.** (Amended) A digital storage device, **characterized in** comprising a binary-input/ternary-output error correction encoder, which comprises an even number of delaying means for delaying an input signal of a binary digital information signal, and modulo 3 adding means for carrying out an operation over a Galois field GF(3) on a signal outputted from the delaying means and an input signal, and uses at least the input signal and final delaying means output signal in an operation over the Galois field GF(3).

**18.** (Amended) A digital storage device, **characterized in** comprising a binary-input/ternary-output error correction encoder in which a generating function generates, with respect to a binary input signal, a ternary output error correction code prescribed by either

$$g(D) = 1 + 2D + D^2 + D^4 + D^5 + D^6$$

or

$$g(D) = 2 + D + 2D^2 + 2D^4 + 2D^5 + 2D^6.$$

**Statement under Art. 19.1 PCT**

Claims 1 through 7, 11 through 13, 17 and 18 make it clear that the two processes of multivaluing and encoding a binary digital information signal are carried out via a single constitution, simultaneously producing a ternary signal.

Furthermore, these amendments are based on the disclosures of lines 24 through 26 on Page 10, lines 11 through 22 on Page 14, lines 11 through 18 on Page 15, and lines 12 through 24 on Page 16.

In Cited Literature 1 (JP2003-209493) (NEC Corporation), which, of the literature cited, is considered to be especially relevant, the point that a binary is made into a multiary by performing data conversion, and this multiary is three-phase modulated is disclosed in Fig. 2, and the point that a binary is made into a ternary by performing data conversion, this ternary is made into an encoded ternary by ternary error correction encoding, and this encoded ternary is three-phase modulated, is disclosed in Fig. 5.

Further, in Cited Literature 2 (JP2003-142349) (NEC Corporation), for conventional technology, the point is disclosed that a binary is made into an encoded binary by binary error correction encoding, this encoded binary is made into an encoded multiary in accordance with binary-multiary conversion, and this encoded multiary is multiary modulated, and for the present invention, the point is disclosed that a binary is made into a multiary by binary-multiary conversion, this multiary is made into an encoded multiary in accordance with non-secondary error correction encoding, and this encoded multiary is multiary modulated.

The points disclosed in these Cited Literatures indicate that the two process of multivaluing and encoding, respectively, are carried out independently, and that two-step processing is required to achieve an encoded multiary. Then, the problem with this binary-multiary conversion is that when n-number of binary signals are converted to p-number of multiary signals, because there is room for signals that do not correspond to binary signals to be generated in a multiary signal, conversion loss occurs, and, in addition, if there is even one error in the p-number of multiary signals, the to-be-restored n-number of binary signals will be completely different, the bit error rate will deteriorate excessively, and what is called error propagation will occur.

In contrast to this, the present invention, by comprising the constitution described hereinabove, makes it possible to implement a binary-input/ternary-output error correction code for which error propagation does not occur and there is no conversion loss.

Fig. 1

Fig. 2

Fig. 3

Fig. 4

Fig. 5A

"00"   "11"   501   " 00"   502

Fig. 5B

"00"   " 11"   503   " 00"   504

Fig. 5C

511

Fig. 5D

512

$513_4$   $513_2$   $513_1$   $513_3$

Fig. 6A

Fig. 6B

Fig. 6C

Fig. 7

Bit error rate

Fig. 8

Fig. 9

Fig. 10

Fig. 11

Fig. 12

<table>
<tr><td colspan="2" align="center"><strong>INTERNATIONAL SEARCH REPORT</strong></td><td colspan="2">International application No.<br>PCT/JP03/12675</td></tr>
</table>

| A. CLASSIFICATION OF SUBJECT MATTER |
|---|
| Int.Cl$^7$  H03M13/25, H04L27/18 |

According to International Patent Classification (IPC) or to both national classification and IPC

| B. FIELDS SEARCHED |
|---|

Minimum documentation searched (classification system followed by classification symbols)
Int.Cl$^7$  H03M13/00-13/53, H04L27/00-27/30

Documentation searched other than minimum documentation to the extent that such documents are included in the fields searched

| Jitsuyo Shinan Koho | 1922–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)
IEEE Xplore ternary phase shift keying
ternary error correcting

| C. DOCUMENTS CONSIDERED TO BE RELEVANT | | |
|---|---|---|
| Category* | Citation of document, with indication, where appropriate, of the relevant passages | Relevant to claim No. |
| P,X<br>P,A | JP 2003-209493 A  (NEC Corp.),<br>25 July, 2003 (25.07.03),<br>Full text; all drawings<br>& EP 1328098 A | 1-12,15-17<br>13,14,18 |
| P,X<br>P,A | JP 2003-143249 A  (NEC Corp.),<br>16 May, 2003 (16.05.03),<br>Full text; all drawings<br>& EP 1309145 A | 1-12,15-17<br>13,14,18 |
| P,A | JP 2003-110644 A  (NEC Corp.),<br>11 April, 2003 (11.04.03),<br>Full text; all drawings<br>& EP 1301001 A | 1-18 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>25 December, 2003 (25.12.03) | Date of mailing of the international search report<br>20 January, 2004 (20.01.04) |
|---|---|
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.

PCT/JP03/12675

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-196690 A (Toshiba Tec Corp.), 14 July, 2000 (14.07.00), Full text; all drawings (Family: none) | 7-10,16 |

Form PCT/ISA/210 (continuation of second sheet) (July 1998)